## Europäisches Patentamt
## European Patent Office
## Office européen des brevets

(19)

(11) Veröffentlichungsnummer : **0 140 057**
**B1**

(12)

# EUROPÄISCHE PATENTSCHRIFT

(45) Veröffentlichungstag der Patentschrift :
**13.12.89**

(51) Int. Cl.⁴ : **G 06 F 11/22**

(21) Anmeldenummer : **84110613.1**

(22) Anmeldetag : **06.09.84**

(54) Verfahren und Vorrichtung zur Signalübertragung.

(30) Priorität : 06.09.83 DE 3332037

(43) Veröffentlichungstag der Anmeldung :
08.05.85 Patentblatt 85/19

(45) Bekanntmachung des Hinweises auf die Patenterteilung : 13.12.89 Patentblatt 89/50

(84) Benannte Vertragsstaaten :
DE FR GB IT SE

(56) Entgegenhaltungen :
WO—A—83 /028 36
DE—A— 2 548 866
US—A— 4 271 512
PATENT ABSTRACTS OF JAPAN, Band 7, Nr. 98 (M-
210)[1243], 26. April 1983; & JP-A-58 20 539 (NISSAN
JIDOSHA K.K.) 07-02-1983
IBM TECHNICAL DISCLOSURE BULLETIN, Band 22,
Nr. 10, März 1980, Seiten 4615-4616, New York, US; S.
MEGURO: "Automatic module detection"

(73) Patentinhaber : ROBERT BOSCH GMBH
Postfach 50
D-7000 Stuttgart 1 (DE)

(72) Erfinder : Schweizer, Hartmut, Dipl.-Ing.
Uhlandstrasse 4/1
D-7015 Korntal 1 (DE)

EP 0 140 057 B1

## Beschreibung

### Stand der Technik

Die Erfindung geht aus von einem Verfahren zur Signalübertragung nach der Gattung des Hauptanspruchs. (Patentanspruch 1). Ein derartiges Verfahren ist beispielsweise aus Patent Abstracts of Japan, Bd. 7, Nr. 98 (M-210) (1 243), 26. April 1983 bekannt.

In der Kraftfahrzeugelektrik finden immer mehr komplexe elektronische Schaltungen Verwendung, mit denen beispielsweise der Zündzeitpunkt oder die Einspritzzeit und Einspritzdauer ermittelt wird. In Abhängigkeit von Fahrzeugparametern wird dabei beispielsweise der Zündimpuls ausgelöst. Um ein sicheres Arbeiten dieser Steuergeräte, die meistens mit Mikroprozessoren arbeiten, zu gewährleisten, ist es Nötig, mittels Diagnosevorrichtungen in regelmäßigen Abständen das ordnungsgemäße Arbeiten der Steuergeräte zu überprüfen. Zu diesem Zwecke werden an die Steuergeräte Diagnosevorrichtungen angeschlossen, mit denen die Funktion des Steuergerätes überprüft werden kann. Die Übertragung der vom Steuergerät erzeugten Signale erfolgt dabei oft in serieller Form auf einer Datenleitung. Um nun das Steuergerät zu veranlassen, Daten an das Diagnosegerät zu übertragen, werden vom Diagnosegerät Stimulisignale abgegeben oder aber es sind Eingriffe im Steuergerät notwendig. Dieses Vorgehen ist jedoch recht umständlich, da durch externe Handgriffe die Datenübertragung veranlaßt werden muß. Einerseits bietet dies die Möglichkeit, daß durch eine Fehlbedienung falsche Daten ausgelesen werden, die auf einen Defekt des Steuergerätes schließen lassen, andererseits kann das Betätigen eines Schalters beispielsweise im Steuergerät dazu führen, daß auch nach dem Einbau in das Fahrzeug der Schalter in der Diagnosestellung verbleibt, so daß nunmehr das Steuergerät im eingebauten Zustand nicht einwandfrei arbeitet.

### Vorteile der Erfindung

Das erfindungsgemäße Verfahren mit den kennzeichnenden Merkmalen des Hauptanspruchs hat demgegenüber den Vorteil, daß nach dem Anschluß eines Diagnosegerätes automatisch die Diagnosedaten übertragen werden. Als weiterer Vorteil des erfindungsgemäßen Verfahrens ist anzusehen, daß zusätzliche Steuerleitungen oder Änderungen an bereits vorhandenen Diagnoseverbindungen nicht vorzusehen sind, da zusätzliche Leitungen oder Schaltkontakte in den Zuleitungen nicht benötigt werden. Eine Vorrichtung nach dem erfindungsgemäßen Verfahren ist daher einfach nachrüstbar, ohne daß Änderungen an den Diagnoseeinrichtungen oder an den Verbindungskabeln vorgenommen werden müssen.

Durch die in den Unteransprüchen aufgeführten Maßnahmen sind vorteilhafte Weiterbildungen und Verbesserungen des im Hauptanspruch angegebenen Verfahrens möglich. Besonders vorteilhaft ist es, die Signalübertragung erst dann erfolgen zu lassen, wenn ein angeschlossenes Diagnosegerät erkannt ist. Durch diese Maßnahme wird sichergestellt, daß mit der Datenübertragung erst dann begonnen wird, wenn eine sichere Verbindung zum Diagnosegerät gegeben ist. Zur Auswertung, ob ein Diagnosegerät angeschlossen ist, ist es vorteilhaft, einen Spannungsvergleicher, insbesondere einen Komparator, zu verwenden, der die Spannung auf, der Datenleitung oder einen Teil davon mit einer Referenzspannung vergleicht. Dies ist eine besonders einfache Maßnahme, die nur geringfügige zusätzliche Aufwendungen erfordert und sehr sicher und zuverlässig arbeitet.

### Zeichnung

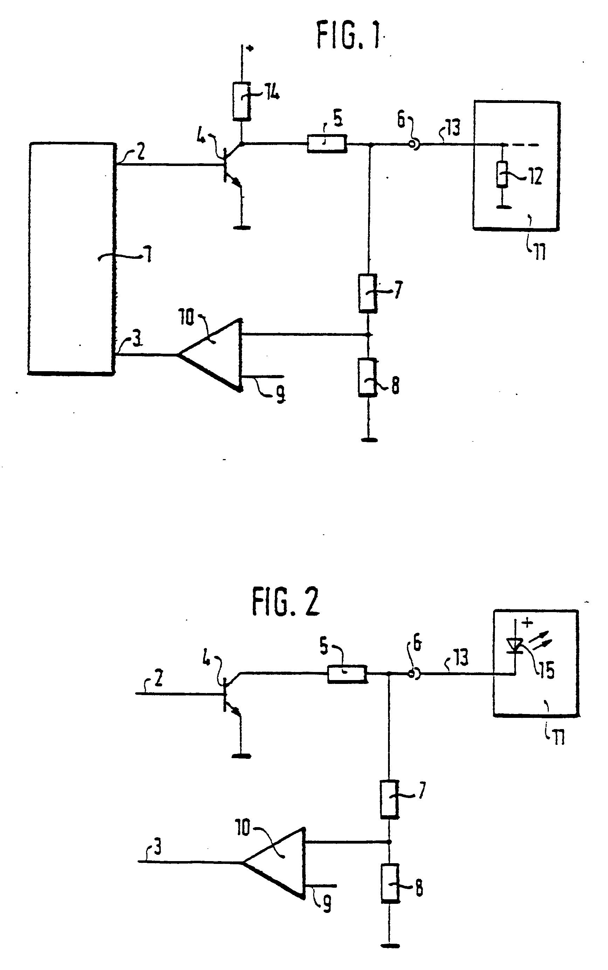

Ausführungsbeispiele der Erfindung sind in der Zeichnung dargestellt und in der nachfolgenden Beschreibung näher erläutert. Es zeigen Figur 1 ein erstes und Figur 2 ein zweites Ausführungsbeispiel.

### Beschreibung der Ausführungsbeispiele

Die Figur 1 zeigt ein Steuergerät 1, wie es beispielsweise als Zündungssteuergerät in Kraftfahrzeugen verwendet ist. Neben den nicht dargestellten Steuerein- und -ausgängen des Steuergerätes 1 weise das Steuergerät 1 einen Diagnoseausgang 2 auf, der an die Basis eines Transistors 4 angeschlossen ist. Der Kollektor des Transistors 4 führt zu einen Widerstand 5 der seinerseits zu einer Steckverbindung 6 führt. Weiterhin ist der Kollektor des Transistors 4 über einen Widerstand 14 mit der positiven Versorgungsspannung verbunden. An die Steckverbindung 6 ist eine Diagnoseleitung 13 angeschlosen, die zu einem Diagnosegerät 11 führt. Der Eingang des Diagnosegerätes 11 weist einen inneren Widerstand 12 auf. Dieser Widerstand ist in Ausführungsbeispiel an Masse geschaltet. Ebenso ist es möglich, daß das Diagnosegerät einen Widerstand aufweist, der gegen eine Versorgungsspannungsleitung geschaltet ist, beispielsweise eine Leuchtdiode, wenn am Eingang des Diagnosegerätes eine galvanische Entkopplung gewünscht ist. Die Erfindung ist jedoch im weiteren mit einem Widerstand erläutert, der gegen Masse geschaltet ist.

Zwischen Widerstand 5 und Steckkontakt 6 ist ein Widerstand 7 angeschlossen, der in Reihe mit einem Widerstand 8 geschaltet ist, wobei der Widerstand 8 zur Masse führt. Zwischen den Widerständen 7 und 8 führt eine Leitung zu einem Eingang eines Komparators 10. An den anderen Eingang 9 des Komparators 10 ist eine Referenzspannung angelegt. Der Ausgang des Komparators 10 steht mit einem Eingang 3 des Steuergerätes 1 in Verbindung, der die Freigabe und das Auslesen der Diagnosesignale veranlaßt. Sämtliche Widerstände und Halbleiterbauelemente, die vor der Steckverbindung 6 liegen, sind nur der Anschauung halber vom Steuergerät 1 abgesetzt gezeichnet. Es ist selbstverständlich, daß diese Bauelemente im Steuergerät integriert sein können.

Mit der gezeigten Schaltungsanordnung ist es für das Steuergerät möglich zu erkennen, ob ein Diagnosegerät 11 angeschlossen ist oder nicht und ob bei einem angeschlossenen Diagnosegerät 11 entsprechende Diagnosesignale übertragen werden. Dazu stellt der Komparator 10 fest, welche Spannung auf der Diagnoseleitung 13 gegeben ist. Werden keine Diagnosesignale übertragen, so liegt der Diagnoseausgang 2 auf einer logischen 0. Dadurch ist der Transistor 4 gesperrt. Über den Widerstand 14 und die Widerstände 5 liegt am Stecker 6 die Betriebsspannung des Steuergerätes an. Am Meßeingang des Komparators 10 bildet sich demzufolge eine hohe Meßspannung aus, die die Referenzspannung am Eingang 9 übersteigt. Dies bewirkt, daß der Freigabeeingang 3 gesperrt ist, so daß Diagnosesignale nicht übertragen werden können.

Wird nun das Diagnosegerät 11 über den Steckkontakt an die Diagnoseleitung 13 mit dem Steuergerät verbunden, so Milden die Widerstände 14 und 5 mit den inneren Widerstand 12 einen Spannungsteiler, der die Spannung am Steckkontakt 6 absinken läßt. Im gleichen Maße sinkt die Spannung am Meßeingang des Komparators 10 ab. Dadurch wird die Referenzspannung am Eingang 9 unterschritten und der Ausgang des Komparators 10 schaltet um. Am Eingang 3 des Steuergerätes 1 liegt nunmehr ein umgeschaltetes Signal an, das das Steuergerät veranlaßt, über seinen Diagnoseausgang 2 in serieller Form Diagnosesignale abzugeben. Der Transistor 4 wird dadurch rhythmisch geöffnet, so daß sich der auf der Datenleitung durch die Widerstände eingeprägte Strom ändert. In gezeigten Fall wird durch das leitend Schalten des Transistors 4 die Spannung zwischen Widerstand 14 und Widerstand 5 kurzgeschlossen, so daß der Strom in der Datenleitung 13 und damit auch die Spannung an Steckkontakt 6 stärker absinkt. Vom Komparator 10 wird daher auch weiterhin das eingesteckte Diagnosegerät 11 erkannt.

Mittels einer umschaltbaren Referenzspannungsquelle am Eingang 9 des Komparators 10 ist es möglich, zu erkennen, ob die Information richtig übertragen ist. Dies geschieht dadurch, daß sich an Meßeingang des Komparators in Abhängigkeit von den Stromschwankungen eine Spannungsschwankung ausbildet, die unterhalb der ursprünglichen Referenzspannung liegt. Liegt nun die neue Referenzspannung zwischen den beiden Spannungswerten, so kann durch das Steuergerät 1 geprüft werden, ob die Diagnosesignale richtig zum Diagnosegerät 11 übertragen sind. Dies ist in besonders einfacher Weise durch den im Steuergerät vorhandenen Mikrocomputer möglich, der am Eingang 3 überprüft, ob die dort anliegende Signalfolge der Signalfolge entspricht, die soeben ausgesandt wurde. Das Steuergerät ist daher in der Lage, die einwandfreie Absendung der Diagnosesignale zu überprüfen.

Das wesentliche ist, daß die Erkennung, ob ein externes Gerät angeschlossen ist, über eine Spannungsmessung erfolgt, während die Übertragung der Signale zum externen Gerät über eine Strommessung im Diagnosegerät 11 erfolgt.

Das Ausführungsbeispiel nach Figur 2 ist ähnlich aufgebaut wie das Ausführungsbeispiel nach Figur 1. Der wesentliche Unterschied liegt darin, daß der Widerstand 14 am Kollektor des Transistors 4 nicht vorgesehen ist und stattdessen im Diagnosegerät 11 ein Widerstand, vorzugsweise die Leuchtdiode 15 eines Optokopplers gegen die positive Versorgungsspannung geschaltet ist. Die Basis des Transistors 4 ist wiederum an den Diagnoseausgang 2 angeschlossen, und in die Diagnoseleitung, die vom Kollektor des Transistors 4 ausgeht, ist der Widerstand 5 geschaltet. Einem Eingang des Komparators 10 ist wieder ein Teil der Diagnosespannung zugeführt, wobei der Teil durch das Verhältnis der Widerstände 7 und 8 zueinander bestimmt ist. Der Ausgang des Komparators 10 wird mit dem Eingang 3 des Steuergerätes verbunden. An der Leitung 9, die an einen weiteren Eingang des Komparators 10 führt, wird die Referenzspannung angeschlossen.

Ist an dem Steuergerät keine Diagnoseeinrichtung angeschlossen, so ist an der Steckverbindung 6 keine Spannung abgreifbar. An dem einen Eingang des Komparators 10 liegt daher keine Spannung an, so daß dadurch erkannt ist, daß ein Diagnosegerät nicht angeschlossen ist. Wird das Diagnosegerät angeschlossen, so gelangt die positive Betriebsspannung des Diagnosegerätes 11 über die Leuchtdiode 15 an den Steckkontakt 6. An dem einen Eingang des Komparators 10 liegt dann eine Spannung an, die größer ist als die Referenzspannung an der Leitung 9. Der Komparator 10 erkennt nunmehr ein angeschlossenes Diagnosegerät und ermöglicht es dem Steuergerät 1, die Diagnosedaten auszulesen. Die weitere Funktionsweise entspricht der, die bereits zuvor beschrieben worden ist. Die Anordnung nach Figur 2 ergibt den weiteren Vorteil, daß bei einem Kurzschluß nach Masse am Steckkontakt 6 die Diagnose nicht ausgelöst wird, so daß bei den hauptsächlichen im Kraftfahrzeug auftretenden Störfällen eine versehentliche Inbetriebnahme der Diagnoseeinrichtung des Steuergerätes nicht erfolgt. Dadurch wird die Betriebssicherheit der Anordnung weiter erhöht.

**Patentansprüche**

1. Verfahren zur Signalübertragung in serieller Form von einem Steuergerät zu einem Diagnosegerät bei Fahrzeugen mittels einer Signalleitung, wobei im Steuergerät mittels einer Spannungsmessung ein angeschlossenes Diagnosegerät zu erkennen ist, dadurch gekennzeichnet, daß die Signalübertragung mittels eines eingeprägten Stromes erfolgt und daß zum Erkennen des angeschlossenen Diagnosegerätes (11) und zur Signalübertragung nur die genannte Signalleitung (13) verwendet wird.

2. Verfahren nach Anspruch 1, dadurch gekennzeichnet, daß die Signalübertragung erfolgt, wenn ein angeschlossenes Diagnosegerät (11) erkannt ist.

3. Vorrichtung zur Signalübertragung von einem Steuergerät zu einem Diagnosegerät nach einem Verfahren nach Anspruch 1 oder 2, dadurch gekennzeichnet, daß das Steuergerät eine Stromquelle (4, 5, 14) zur Übertragung der Signale aufweist und daß an die Signalleitung (13) ein Spannungsvergleicher (10) angeschlossen ist.

4. Vorrichtung nach Anspruch 3, dadurch gekennzeichnet, daß zum Schalten des Spannungsvergleichers (10) die Spannung auf der Signalleitung (13) oder ein Teil davon mit einer Referenzspannung verglichen wird.

5. Vorrichtung nach Anspruch 4, dadurch gekennzeichnet, daß die Referenzspannung umschaltbar ist, wenn ein angeschlossenes Diagnosegerät (11) erkannt worden ist.

## Claims

1. Method for signal transmission in serial form from a control device to a diagnostic device in vehicles by means of a signal line, whereby it is possible in the control device to detect a connected diagnostic device by means of a voltage measurement, characterized in that the signal transmission takes place by means of an impressed current, and in that only the said signal line (13) is employed for detecting the connected diagnostic device (11) and for signal transmission.

2. Method according to Claim 1, characterized in that the signal transmission takes place when a connected diagnostic device (11) has been detected.

3. Device for signal transmission from a control device to a diagnostic device according to a method according to Claim 1 or 2, characterized in that the control device has a current source (4, 5, 14) for transmitting the signals, and in that a voltage comparator (10) is connected on the signal line (13).

4. Device according to Claim 3, characterized in that, for switching the voltage comparator (10), the voltage on the signal line (13) or a part thereof is compared with a reference voltage.

5. Device according to Claim 4, characterized in that the reference voltage is reversible when a connected diagnostic device (11) has been detected.

## Revendications

1. Procédé et dispositif de transmission de signal sous forme sérielle, depuis un appareil de commande jusqu'à un appareil de diagnostic pour véhicules, au moyen d'une ligne de signalisation, un appareil de diagnostic étant reconnu comme raccordé dans l'appareil de commande au moyen d'une mesure de tension, caractérisé en ce que la transmission de signal s'effectue au moyen d'un courant qui est appliqué et que l'on utilise uniquement le signal évoqué (13) pour reconnaître que l'appareil de diagnostic (11) est raccordé et pour la transmission du signal.

2. Procédé selon la revendication 1, caractérisé en ce que la transmission du signal s'effectue si l'on a reconnu qu'un appareil de diagnostic (11) est raccordé.

3. Dispositif pour la transmission de signal à partir d'un appareil de commande vers un appareil de diagnostic, selon un procédé selon la revendication 1 ou 2, caractérisé en ce que l'appareil de commande présente une source de courant (4, 5, 14) pour la transmission des signaux et en ce qu'un comparateur de tension (10) est raccordé à la ligne de signalisation (13).

4. Dispositif selon la revendication 3, caractérisé en ce que lors du branchement du comparateur de tension (10), la tension régnant sur la ligne de signalisation (13), ou une partie de celle-ci, est comparée à une tension de référence.

5. Dispositif selon la revendication 4, caractérisé en ce que la tension de référence est commutable si on a reconnu qu'un appareil de diagnostic (11) est raccordé.

# FIG. 1

# FIG. 2

1